# EUROPEAN PATENT APPLICATION

(11) **EP 2 858 468 A1**
(43) Date of publication of application: **08.04.2015**
(21) Application number: 13187391.1
(22) Date of filing: 04.10.2013
(51) Int. Cl.: H05K 3/04, H05K 1/11

(54) **Method and system for manufacturing a laminated sheet with a conductive pattern**

(71) Applicant: Cartamundi Turnhout N.V., 2300 Turnhout (BE)
(72) Inventor: Nietvelt, Steven Karel Maria, 2300 Turnhout (BE)
(74) Representative: Plas, Axel Ivo Michel

(57) **Abstract**

According to an embodiment of a first aspect of the invention a method is provided for manufacturing a laminated sheet comprising a conductive target layer according to a target pattern. The method comprises providing a first non-conductive base layer (5), then providing (15) a first conductive layer (6) comprising a first conductive pattern (7) on this first non-conductive base layer (5). The conductive pattern (7) being a subset of the target pattern. In a further step, a second conductive layer (8) comprising a second conductive pattern (9) being a subset of said target pattern is provided on the first conductive layer (6) such that the first (7) and second conductive pattern (9) jointly form the target pattern and such that overlapping portions of the first and second conductive pattern are electrically contacting.

## Description

### Field of the Invention

The present invention generally relates to the manufacturing of laminated sheets comprising layers of conductive material.

### Background of the Invention

Nowadays, laminated sheets that embed visible or non-visible conductive patterns are manufactured. Typically, after the manufacturing of the sheet, it is cut in smaller portions resulting in cards, tags or any other desired forms.

In one application, the cards are designed as interactive play cards for use in collectible card games or as trade cards. The combination of the conductive pattern with a dielectric, i.e. non-conductive, paper or plastic layer may then be readable by capacitive sensing multi-touch devices having a capacitive sensing touch screen such as tablet pc's, smartphones, some types of gaming consoles or all-in-one computers. This way, the card can be detected by the device or more complex user interactions are possible by identification or tracking of the card based on the detected conductive patterns resulting in an enhanced user experience.

In another application, the conductive layers are used for connecting IC components within the cards or for constructing an antenna or resonance circuit. Such cards may be designed as security tags that can be detected when a shoplifter leaves a shop with a consumer good with such a security tag attached to it. Such a card may also embed Near Field Communication technology (NFC) allowing communication and information exchange with such a card.

WO2010/043422 discloses a laminated sheet with a conductive information layer having a conductive pattern on an insulating substrate. The conductive layer is applied as transfer foil on the substrate by a cold foil technique.

A problem with the above technique is that the conductive layer may exhibit small interruptions or cracks in the pattern. These interruptions may not be visible and need to be detected by a testing procedure. The interruptions most likely occur where the pattern is very narrow, for example in connecting lines between larger areas of the pattern. The interruptions are also most likely to occur on the sides of the laminated sheet. Therefore, cards that are positioned on the sides of a sheet will exhibit a larger production error ratio than cards that are positioned in the middle of the sheet.

### Summary of the Invention

It is an object of the present invention to overcome the above disadvantage. This is achieved, in a first aspect, by a method for manufacturing a laminated sheet comprising a conductive target layer according to a target pattern. The method comprises, in a first step, providing a first non-conductive base layer and, in a second step, providing a first conductive layer comprising a first conductive pattern on this first non-conductive base layer. The first conductive pattern is a subset of the target pattern. In a third step, the method comprises providing a second conductive layer comprising a second conductive pattern being a subset of the target pattern on the first conductive layer such that the first conductive pattern and the second conductive pattern jointly form the target pattern. The providing the second conductive layer is also done such that overlapping portions of the first conductive pattern and the second conductive pattern are electrically contacting. The first conductive pattern and the second conductive pattern comprise at least one such overlapping portion.

Thus, the laminated sheet manufactured according to the method above, comprises a single conductive layer, i.e. the target layer, composed of the first and second conductive layer. As the first and second conductive layer are provided on top of each other, they make an electrical connection by the parts of the pattern that overlap, i.e. at the overlapping portions the top surface of the first conductive layer makes electrical contact with the bottom surface of the second conductive layer. As a consequence, if interruptions would appear in the overlapping regions of the first and second pattern of the first and second layer, there would not yet occur an interruption in the target layer and, thus, in the target pattern. It is thus an advantage that possible interruptions in the target conductive layer by production errors are greatly reduced as it is very unlikely that two interruptions in the first and second pattern of the first and second conductive layer respectively will occur in the same exact location. As the first and second layer are in electrical contact with each other over the surface of the overlapping portions, interruptions in one of the overlapping portions of the first or second layer will be bypassed by the other layer.

The first and second conductive patterns are subsets of the target pattern in that respect that if the first and second patterns would be positioned on top of each other as in the resulting laminated sheet, the target pattern would be observed. The first and/or second pattern may thus also be identical to the target pattern. In this case, there is one single overlapping portion which is identical to the complete first, second and target pattern. The advantage of having both first and second patterns identical to the target pattern is that the production may be much easier as only one pattern needs to be designed. Moreover, the overlapping portions will then be the same as the complete target pattern, minimizing interruptions in the target conductive layer to the minimum.

Optionally, the non-conductive base layer may be provided with a further finishing on the other side, i.e. the side not covered by the conductive layer. Such a finishing layer may be a protective and/or ground coating or a decorative print. This finishing may be applied before or after the manufacturing of the sheet according to the method above.

By the combination of the non-conductive base layer and the conductive target layer, the target pattern may encode an information layer that can be detected and read by a capacitive sensing touch device having a capacitive sensing touch screen. The non-conductive base layer may for example be made of paper or plastic. To have the conductive layer detectable by a capacitive touch screen, the non-conductive base layer may not be too thick, preferable thinner than 400 micrometres, more preferably between 100 and 400 micrometres.

According to an embodiment the providing the second conductive layer further comprises providing a second non-conductive base layer and providing the second conductive layer reversely on the second non-conductive base layer forming an intermediate sheet. Then, the intermediate sheet is provided on the first conductive layer such that the second conductive layer is provided on the first conductive layer.

As a result, a laminated sheet is obtained where the target conductive layer is comprised between the first and second base layer. It is an advantage that the first as well as the second base layer may first be provided with a finishing layer before the conductive layers are provided keeping the risk of further damaging the target conductive layer low when applying the finishing layers. It is a further advantage that the providing of the first conductive layer on the first base layer and the providing of the second conductive layer on the second base layer is a similar process which may be conducted by the same production techniques, keeping the complexity of the manufacturing process low.

Advantageously, the first and second non-conductive base layer are part of a single non-conductive base layer.

In other words, the first and second base layer are each one half of this single base layer. This allows to perform further processing steps such as finishing on the first and second base layer in one production step, i.e. directly on the single base layer. For example, the printing of a decorative design for the front and back of the laminated sheet may be done in one printing step on the single base layer.

More advantageously, the providing the first conductive layer and the providing the second conductive layer are performed in one step by providing a single conductive layer comprising the first and second conductive layer on the single non-conductive base layer.

Similarly, the provision of the conductive layers may thus be done in one single manufacturing step, further simplifying the production process of the laminated sheet.

According to a preferred embodiment, the providing the intermediate sheet on the first conductive layer comprises folding the single non-conductive base layer and flipping the second base layer onto said first base layer along one or more folding lines.

Thus, in order to have the first conductive and second conductive layer on top of each other the assembly of the single base layer and single conductive layer is folded such that the first and second conductive layers are brought on top of each other and such that the first and second conductive patterns form the target pattern. This allows to perform the alignment of the first and second conductive layers by determining and applying the one or more folding lines.

Alternatively, the providing the intermediate sheet on the first conductive layer may comprise cutting the single non-conductive base layer and single conductive layer and flipping the second base layer onto said first base layer.

According to a further embodiment of the folding, the one or more folding lines is one single folding line dividing the single non-conductive base layer in two halves. The first conductive pattern of the first conductive layer and the second conductive pattern of the second conductive layer is then provided mirror symmetrical according to this single folding line.

This allows an easy application of the folding as only one folding operation is required. Also the design of the second pattern may be as simple as mirroring the first pattern and applying both patterns as the single conductive layer next to each other on the single base layer.

It should be noted that two halves do not necessarily refer to two exact identical pieces. The two halves may differ in size, for example by a maximum of 20% or, more preferably, by a maximum of 5%. However, this inaccuracy would inevitably result in a loss of effective area, i.e. a loss in material.

According to an embodiment, the providing a first conductive layer and the providing a second conductive layer is done such that first parts of the first conductive layer are positioned more towards the middle of the single non-conductive base layer than corresponding second parts of the second conductive layer. The first parts and the corresponding second parts defining a same area on the resulting laminated sheet.

In other words, as both the first and second pattern are provided on the single base layer, they can be arranged as such that corresponding parts of the first and second pattern do not appear at the same distance from the middle of the single base layer. To provide the first conductive layer on the second conductive layer, either folding or cutting of the single base layer may be performed. In some techniques for providing the conductive layers on a base layer, such as for example cold foil techniques, the amount of production errors is the lowest towards the middle of the sheet, i.e. the middle of the single base layer. Therefore, it is an advantage that conductive layer parts more towards the middle of the single conductive layer are combined with conductive layer parts more towards the sides of the single conductive layer, thus further minimizing the change for production errors.

A part may be seen as a target portion of the laminated sheet that will be cut out from it after production of the sheet. For example, a laminated sheet may comprise a plurality of cards that are cut out from the sheet.

According to a further embodiment, the above principle is combined with the folding. The one or more folding lines then correspond to two folding lines. A first folding line of the two folding lines is positioned at substantially 25% of the width of the single non-conductive layer and a second folding line of the two folding lines is positioned at substantially 75% of the width of said single non-conductive layer. Substantially the first 25% and substantially the last 25% of the width of the single base layer defined by the sections outside the two folding lines correspond to two halves of the second non-conductive base layer and the substantially centre 50% of the width of the single base layer defined by the section inside the two folding lines correspond to the first non-conductive base layer. The folding then comprises folding these two halves of the second non-conductive base layer along the two folding lines onto the first non-conductive base layer in order to obtain a window folded laminated sheet.

By this windows folding, parts of the second pattern that are positioned on the outside of the single conductive layer and thus on the outside of the single base layer, will be positioned on top of corresponding parts of the first pattern that are positioned near the middle of the single conductive layer. This allows to minimize production errors such as interruptions in the target conductive layer by simple folding along two folding lines.

Optionally, a cold foil technique may be performed for the providing the first conductive layer and/or the providing the second conductive layer.

In a cold foil technique, the conductive pattern is first applied in glue on the base layer. Then a conductive foil is laminated onto this base layer. After the ink has dried, which may be instantaneously, the foil is removed only leaving foil where the glue was applied resulting in a conductive layer. It's is an advantage that with the cold foil technique, no heating of the base layers or conductive layers is required nor expensive stamping is needed.

Alternatively the providing the first conductive layer and/or the providing the second conductive layer is performed by hot stamping.

In hot stamping the pattern is defined by a stamp. A conductive foil containing glue is then pressed by the heated stamp onto the base layer. By the heat, the glue becomes liquid under the stamp gluing the foil onto the base layer. An advantage of hot stamp technology is that less interruptions in the conductive target layer will occur than when using the cold foil technique. A disadvantage of the hot stamp technique is that it leaves an impression of the pattern on the base layer which may be undesirable for the end product. Therefore, the hot stamp techniques may be combined with the provision of the second base layer such that the impressions onto the first and second base layers will occur on the inside of the laminated sheet and thus invisible in the final laminated sheet.

In a second aspect of the invention according to claim 12, the invention also relates to a system comprising the means to perform the above method for manufacturing a laminated sheet.

In a third aspect, the invention relates to a laminated card cut from a laminated sheet manufactured by any of the above methods.

It should be noted that the term conductive pattern refers to a geometrical design rather than a physical means whereas the term conductive layer refers to the physical material provided in the form of a layer and embodying the related conductive pattern.

It should further be noted that, when a layer is provided on another layer, the layer is adhered to the underlying layers, for example by glue or other techniques as set out in the below detailed description. If the second conductive layer is provided on the first conductive layer, this refers to the order of appearance and adherence of the layers. As the first conductive layer defines a pattern, the second layer may also be partially in contact with and adhered to the first base layer. The same reasoning applies to the other layers.

### Brief Description of the Drawings

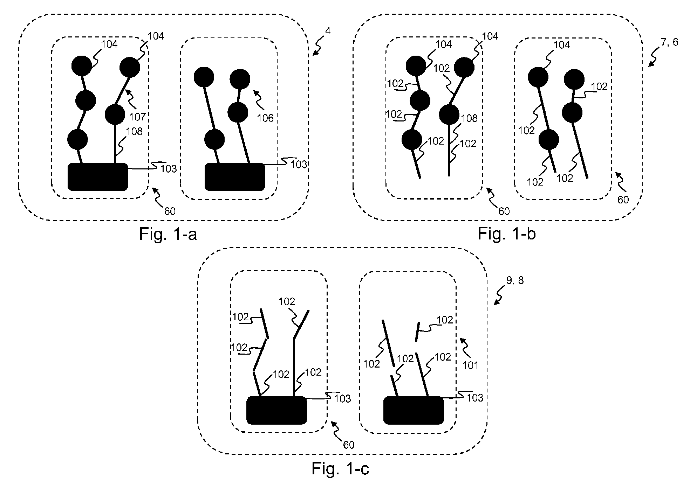

Fig. 1-a illustrates an exemplary embodiment of a target conductive pattern;

Fig. 1-b and 1-c illustrate first and second conductive patterns forming the target pattern of Fig. 1-a;

Fig. 2 illustrates a method for manufacturing a laminated sheet according to an embodiment of the present invention;

Fig. 3 illustrate a method for manufacturing a laminated sheet according to a further embodiment of the present invention;

Fig. 4-a and Fig. 4-b illustrate steps of a method for manufacturing a laminated sheet according to a further embodiment of the present invention;

Fig. 5 illustrates a step of a method for manufacturing a laminated sheet according to a further embodiment of the present invention;

Fig. 6-a, 6-b and 6-c illustrate laminated sheets manufactured according to different embodiments of the present invention.

### Detailed Description of Embodiment(s)

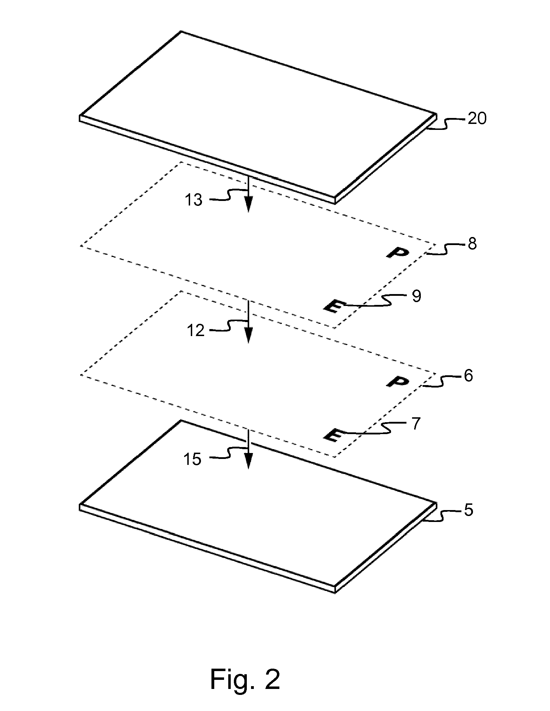

Fig. 2 illustrates manufacturing steps for producing a laminated sheet according to an embodiment of the present invention. First, a non-conductive base layer 5 is provided. The base layer may be made of paper or plastic with a typical thickness between 100 and 400 micrometres (µm). Then, in a next step 15, a first conductive layer 6 is provided on the non-conductive base layer 5. This conductive layer 6 comprises a conductive pattern 7. In Fig. 2 the pattern is formed by the letters E and P for the sake of representation and illustration. Then, in a next step 12, a second conductive layer 8 is provided on top of the first conductive layer 6 and thus also on top of the non-conductive base layer. Also the second conductive layer 8 comprises a conductive pattern 9 formed by the same letters E and P of the first conductive pattern 7. The two patterns 7 and 9 of Fig. 2 are thus identical making the conductive layers 6 and 8 to completely overlap with each other.

In Fig. 2 and in the following figures, the conductive layers are outlined by dashed lines for illustrative purpose as they do not cover the complete surface of the sheet. When applied, the conductive layer is merely composed of the conductive pattern rather than the complete surface.

Different techniques may be used for providing the first and second conductive layer. A first technique for example is the cold foil technique. Using this technique, glue is applied to the base layer 5, but only on the area defined by the pattern 7. Then, using a laminator, a conductive foil is laminated on the glued base layer. When leaving the laminator, the foil touching the glue sticks to the base layer 5 while the remaining foil is removed leaving a conductive layer 6 of foil according to the pattern 7 adhered to the base layer 5. The exact same technique may be used for applying the second conductive layer 8 in step 12. When applying the second conductive layer 8, a conductive glue may be used to ensure that the conductive patterns are electrically contacting each other. The foil may be a metallic foil, for example a gold foil, silver foil or aluminium foil with a preferred thickness in the range of 1 µm to 100µm. The thinner the foil, the less visible it will be in the final laminated sheet but the more prone it may be to disruptions in the pattern.

Another alternative technique that may be used for applying the first and second conductive layer is hot stamping or hot foil. With this technique, a die or stamp is made with the shape of the pattern to be applied in the conductive layer. The die is then heated and pressed on the substrate with a conductive foil in between. As the conductive foil also comprises a layer of glue, the glue liquefies under the die or stamp and the foil adheres to the substrate under the stamp and thus according to the pattern defined by the stamp. Again, when applying the second conductive layer 8, it is preferred to use a conductive glue to ensure the electrical contact between the two conductive patterns 7 and 9.

Yet another alternative technique that may be used for applying the first and second conductive layer is by printing the patterns with conductive ink onto the base layer 5 or first conductive layer 6.

After applying the two conductive layers 6 and 8, the surface of the obtained laminated sheet may be further finished. This may be done by providing in a step 13 a second non-conductive base layer 20 on top of the second conductive layer 8 as also illustrated by Fig. 2. The material of the second base layer may be the same as the first base layer, for example paper or plastic. The two base layers may also be further finished by a decorative print. The decorative print may also be provided on the base layers 5 and 20 before the conductive layers 6 and 8 are applied. An advantage of applying the second base layer 20 is that impressions or unevenness' caused by the provision of the conductive layers 6 and 8 made in the top surface of the base layer 5 may be masked and made invisible in the final laminated sheet.

Alternatively, the finishing of the laminated sheet may be done be applying a painted or printed coating after the provision of the second conductive layer and directly printing a design on the coating.

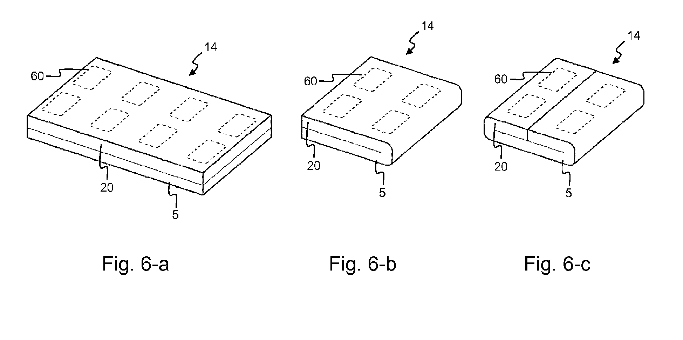

The laminated sheet 14 obtained from manufacturing it according to the embodiment illustrated by Fig.2 is shown in Fig. 6-a. In between the non-conductive base layers 5 and 20 will be the two conductive layers on top of each other. As the two conductive layers were provided on top of each other, they form a single conductive layer as they make full contact by their respective top and bottom surface. After the production of the laminated sheet, the sheet may be further cut to obtain smaller portions 60, for example in the form of cards to be used as interactive gaming cards or trading cards.

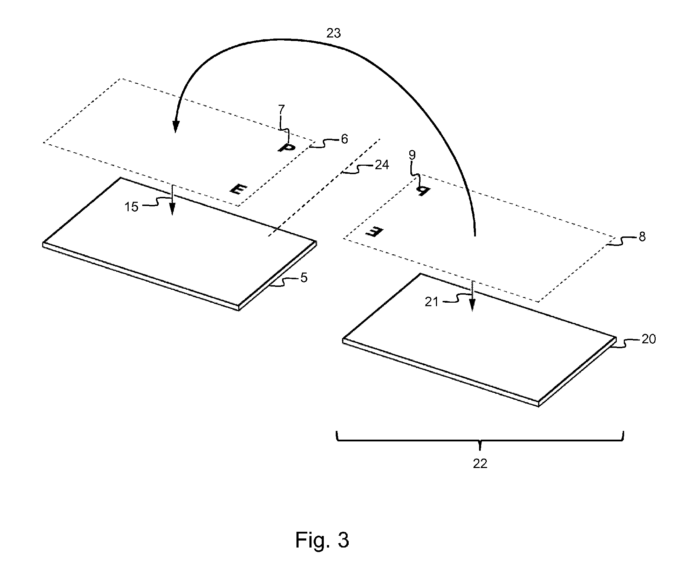

Fig. 3 illustrates manufacturing steps for producing a laminated sheet according to a second embodiment of the present invention. Similar to the first embodiment, in a first step 15, a conductive layer 6 defining a conductive pattern 7 is provided on a non-conductive base layer 5. Then, in a next step 21, a second conductive layer 8 is provided on a second non-conductive base layer 20. The second conductive layer defines (or thus comprises) a second conductive pattern 9 which is mirror symmetrical with the first conductive pattern 6 along the symmetry line 24. The base layer 20 and conductive layer 8 can then be regarded as an intermediate sheet 22.

Then, in a next step 23, this intermediate sheet 22 is flipped and provided on top of the first conductive layer 6 as indicated be the arrow 23. As the pattern 9 was defined as mirror symmetrical to pattern 7 the two patterns will nicely overlap by their complete surface and an electrical contact will thus be made between the two conducting layers over their complete surfaces. For the step 23, a glue may be used to fix the intermediate sheet 22 onto the conductive layer 6 and the non-conductive base layer 5. To ensure electrical contact between the two conductive patterns 7 and 9, a glue may be applied in between but not on one of the patterns 7 and 9. This way the laminated sheet will be formed by gluing the base layers 5 and 20 together by applying glue where there is no conductive pattern. To obtain a better adherence of the layers, a conductive glue may further be applied on one of the conductive patters ensuring a good electrical contact between the conductive patterns 7 and 9.

For the provision of the conductive layers 6 and 8 on the respective base layers 5 and 20, the same techniques as in the first embodiment above may be used. Preferably the two base layers 5 and 20 have equal sizes. The end result, i.e. the laminated sheet 14, is depicted in Fig. 6-a and is thus the same as in the first embodiment.

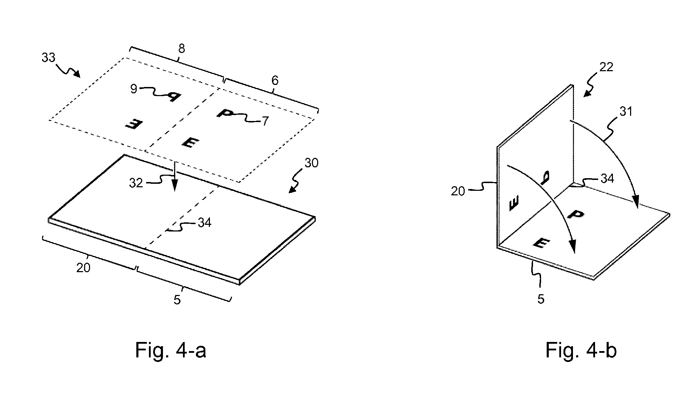

Fig. 4-a and Fig. 4-b illustrate manufacturing steps for producing a laminated sheet according to a third embodiment of the present invention. Similar to the second embodiment, again a first non-conductive base layer 5 and a second non-conductive base layer 20 is used, however now they are part of the same single non-conductive base layer 30 of which one half is the first base layer 5 and the other half is the second base layer 20. The provision of the first conductive layer 6 and the second conductive layer 8 is then performed in a single manufacturing step 32 by providing a single conductive layer 33 comprising the first conductive layer 6 on one half and the second conductive layer 8 on the other half. Similar to Fig. 3 the conductive pattern 7 is mirror symmetrical according to the conductive pattern 9 along a symmetry line 34. The provision of the single conductive layer 33 onto the base layer 30 may again be done by the above described techniques, i.e. cold foil, hot stamping or conductive printing.

In a second step 31, the sheet comprising the base layer 20 and the conductive layer 8 is then folded along the symmetry line 34 onto the conductive layer 6 and the non-conductive base layer 5. To adhere to two layers, glue or any other adhesive material may be used as long as it allows to make an electrical connection between the corresponding surfaces of the first and second conductive layers 6 and 8. As the folding line 34 is the same line that defines the mirror symmetrical patterns 7 and 9, the corresponding surfaces of the patterns will nicely overlap after the folding 31.

Fig 6-b illustrates a laminated sheet 14 produced by the steps according to the second embodiment illustrated by Fig. 4-a and Fig. 4-b.

Alternatively to the folding 31, the intermediate sheet comprising the layers 30 and 33, may also be cut along the symmetry line 34. Instead of the folding 31, the flipping 23 as illustrated in Fig.3 by the second embodiment is then performed to get the end laminated sheet.

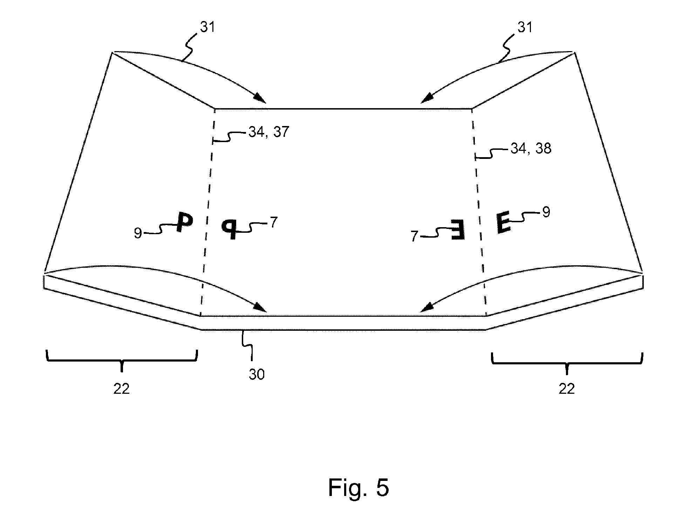

Fig. 5 illustrates manufacturing steps for producing a laminated sheet according to a fourth embodiment of the present invention. Similar to the second embodiment, the first and second conductive layer 6 and 8 are applied together as a single conductive layer 33 onto a single non-conductive base layer 30. The first conductive layer is now provided in the middle of the base layer 30 along its width whereas the second conductive layer is provided as two parts on both sides of the base layer 30. The second conductive pattern 9 on the left side of the base layer is mirror symmetrical along the symmetry line 37 with the left half of the first conductive pattern 7. The second conductive pattern 9 on the right side of the base layer is mirror symmetrical along the symmetry line 38 with the right half of the first conductive pattern 7. This way, the symmetry line 37 is at 25% of the width of the laminated sheet when counting from the left side and the symmetry line is at 75% of the width of the laminated sheet when counting from the left side.

Then, in a folding step 31, the left 25% and the right 25% of the sheet is window folded and glued such that the first and second conductive layers make electrical contact with each other along their overlapping surfaces. The end result of this manufacturing process, i.e. the laminated sheet 14, is illustrated in Fig. 6-c.

As indicated before in Fig. 6-a, Fig. 6-b and Fig. 6-c, the laminated sheet manufactured according to the embodiments above may be further processed by cutting the sheet 14 to obtain several smaller portions in the form of cards 60. Fig. 1-a illustrates a target conductive pattern 4 to be provided on a non-conductive layer. The pattern 4 is subdivided in two patterns 106 and 107 each respectively to end up in cards 60 cut from the laminated sheet. The target patterns 106 and 107 are detectible by a capacitive touch sensor screen when such a card is positioned in such a screen. When a card is on the screen, the surface 103 is to be touched by a user not to disturb the identification of the card and to load electrical charge from the user's body onto the conductive pattern. This also allows the distribution of electrical charges along the conductive pattern 107. A touch device comprising a capacitive touch screen such as for example a tablet or smartphone may then identify the large areas 103 and 104 of the pattern as they mimic a touch by a user's finger. The conductive lines 108 are used to conduct the electrical charges to the bigger areas 104 and are thin enough not to be detected by the touch screen.

According to the above embodiments the target pattern 4 and thus the conductive patterns 106 and 107 of the respective cards 60 are provided by a first conductive layer 6 and a second conductive layer 8 provided on top of each other. Fig. 1-b illustrates an exemplary embodiment of the first conductive pattern 7 defined by the first conductive layer 6. The first conductive layer 6 will only provide parts of the target pattern 4, i.e. the large surfaces 104 and the interconnecting lines 108. The second conductive layer 8 will provide another subset of the target pattern 4, i.e. the large touch surface 103 and, again, the interconnecting lines 108. When the two conductive layers are then provided on top of each other, they jointly form the target conductive layer defining the target conductive pattern 4. As there is no isolating material in between the two layers 6 and 8 and as the two conductive layers 6 and 8 comprise overlapping portions 102, i.e. the interconnecting lines 108, the two conductive layers 6 and 8 will be electrically connected with each other. This is established by the electrical contact between the overlapping portions 102 of the two conductive patterns 7 and 9 and thus the two conductive layers 6 and 8.

In order not to detect the interconnecting lines 108, they are made very thin, preferably thinner than 2mm. Therefore, when depositing the conductive layers by for example cold foil or hot stamping, small interruptions in the lines may occur. As cold foil and hot stamp techniques are primarily used for aesthetic reasons, i.e. decorative printing or lamination, these interruptions, which may be very small and thus invisible to the human eye, are generally not an issue. However, when using these techniques for providing a conductive patterns these invisible interruptions cause a malfunctioning of the resulting interactive card or circuit embedded in the laminated sheet. The provision of the second layer solves this issue as it is very unlikely that two disruptions of the lines 108 in the two layers will occur in exactly the same position.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A method for manufacturing a laminated sheet (14) comprising a conductive target layer according to a target pattern (4), said method comprising:
- providing a first non-conductive base layer (5);
- providing (15) a first conductive layer (6) comprising a first conductive pattern (7) on said first non-conductive base layer (5); said first conductive pattern (7) being a subset of said target pattern (4);
- providing a second conductive layer (8) comprising a second conductive pattern (9) being a subset of said target pattern (4) on said first conductive layer (6) such that:
- said first conductive pattern (7) and said second conductive pattern (9) jointly form said target pattern (4); and
- overlapping portions (102) of said first conductive pattern and said second conductive pattern are electrically contacting; said first conductive pattern and said second conductive pattern comprising at least one such overlapping portion (102).

2. A method according to claim 1 wherein said first (7) and second (9) conductive pattern are identical to said target pattern (4); said overlapping portions corresponding to the complete first and second conductive pattern; said first and second conductive pattern being identical to said target pattern.

3. A method according to claim 1 or 2 wherein said providing said second conductive layer comprises:
- providing a second non-conductive base layer (20);
- providing (21) said second conductive layer (8) reversely on said second non-conductive base layer (20) forming an intermediate sheet (22);
- providing (23) said intermediate sheet (22) on said first conductive layer (6) such that said second conductive layer (8) is provided on said first conductive layer (6).

4. A method according to claim 3 wherein said first (5) and second non-conductive base layer (20) are part of a single non-conductive base layer (30).

5. A method according to claim 4 wherein said providing said first conductive layer (6) and said providing said second conductive layer (8) are performed in one step by providing (32) a single conductive layer (33) comprising said first and second conductive layer on said single non-conductive base layer (30).

6. A method according to claim 4 or 5 wherein said providing said intermediate sheet (22) on said first conductive layer (6) comprises folding (31) said single non-conductive base layer (30) and flipping said second base layer onto said first base layer along one or more folding lines (34,37,38).

7. A method according to claim 6 wherein said one or more folding lines is one single folding line (34) dividing said single non-conductive base layer (30) in two halves; and wherein said first conductive pattern (7) of said first conductive layer (6) and said second conductive pattern (9) of said second conductive layer (8) is provided mirror symmetrical according to said single folding line (34).

8. A method according to any one of claims 4 to 6 wherein said providing a first conductive layer and said providing a second conductive layer is done such that first parts of said first conductive layer are positioned more towards the middle of said single non-conductive base layer (30) than corresponding second parts of said second conductive layer; said parts and said corresponding parts defining a same area on said laminated sheet (14).

9. A method according to claim 8 and 6 wherein said one or more folding lines correspond to two folding lines (37, 38); a first folding line (37) of said two folding lines being positioned at substantially 25% of the width of said single non-conductive layer (30) and a second folding line (38) of said two folding lines being positioned at substantially 75% of the width of said single non-conductive layer (30); and wherein substantially the first 25% and substantially the last 25% of the width of said single base layer (30) defined by the sections outside said two folding lines correspond to two halves of said second non-conductive base layer; and wherein the substantially centre 50% of the width of said single base layer (30) defined by the section inside said two folding lines correspond to said first non-conductive base layer; and wherein said folding comprises folding said two halves of said second non-conductive base layer along said two folding lines onto said first non-conductive base layer in order to obtain a window folded laminated sheet.

10. A method according to any one of the preceding claims wherein said providing said first conductive layer and/or said providing said second conductive layer is performed by a cold foil technique.

11. A method according to any one of claims 1 to 9 wherein said providing said first conductive layer and/or said providing said second conductive layer is performed by hot stamping.

12. A system for manufacturing a laminated sheet (14) comprising a conductive target layer according to a target pattern (4), said system comprising:
- means for providing a first non-conductive base layer (5);
- means for providing a first conductive layer (6) comprising a first conductive pattern (7) on said first non-conductive base layer (5); said first conductive pattern (7) being a subset of said target pattern (4);
- means for providing a second conductive layer (8) comprising a second conductive pattern (9) being a subset of said target pattern (4) on said first conductive layer (6) such that:
- said first conductive pattern (7) and said second conductive pattern (9) jointly form said target pattern (4); and
- overlapping portions (102) of said first conductive pattern and said second conductive pattern are electrically contacting; said first conductive pattern and said second conductive pattern comprising at least one such overlapping portion (102).

13. A laminated card cut from a laminated sheet (14) manufactured by the method according to any one of claims 1 to 11.
